# EUROPEAN PATENT APPLICATION

(11) **EP 2 963 690 A1**
(43) Date of publication of application: **06.01.2016**
(21) Application number: 14756977.6
(22) Date of filing: 27.02.2014
(51) Int. Cl.: H01L 31/048

(54) **SOLAR CELL MODULE MANUFACTURING METHOD AND SOLAR CELL MODULE**

(30) Priority: 01.03.2013 JP 2013040571
(71) Applicant: Bridgestone Corporation, Tokyo 104-8340 (JP)
(72) Inventor: INAMIYA Takato, Yokohama-shi Kanagawa 244-8510 (JP); KATAOKA Hisataka, Yokohama-shi Kanagawa 244-8510 (JP); ARAAKE Satoshi, Yokohama-shi Kanagawa 244-8510 (JP); KAGA Norihiko, Kodaira-Shi Tokyo 187-8531 (JP); TARUTANI Yasunori, Kodaira-Shi Tokyo 187-8531 (JP)
(74) Representative: Oxley, Robin John George
(86) International application number: PCT/JP2014/054854
(87) International publication number: WO 2014/133074

(57) **Abstract**

To provide a method for manufacturing a solar cell module that can prevent cell displacement and cell cracking in heating and pressurizing, and to provide a solar cell module in which poor appearance is improved and the cracking of the photovoltaic element is reduced by using this method.

A method for manufacturing a solar cell module in which a light-receiving side sealing film 13A and a backside sealing film 13B are each formed of a different resin composition from each other selected from a resin composition A and a resin composition B, both of the sealing films are heated when the pressurizing is initiated so as to reach to a minimum temperature X°C and a maximum temperature Y°C, the resin composition A has a viscosity of 5.0×10⁴ Pa·s or less at the temperature X°C, and the resin composition B has a viscosity of 7.0×10⁴ Pa·s or less at the temperature X°C and has a viscosity of 2.0×10⁴ Pa·s or more at the temperature Y°C.

## Description

### Technical Field

The present invention relates to a method for manufacturing a solar cell module and a solar cell module, and particularly relates to a method for manufacturing a solar cell module that can prevent the displacement and cracking of photovoltaic elements in the modularization and a solar cell module produced by the method.

### Background Art

In general, solar cell modules have a structure in which a light-receiving side sealing film and a backside sealing film that are disposed between a light-receiving side transparent protective member and a backside protective member (back cover) seal a photovoltaic element. As a sealing film used for a light-receiving side and a backside, for example, a film of an ethylene-polar monomer copolymer such as an ethylene-vinyl acetate copolymer (EVA) has been preferably employed.

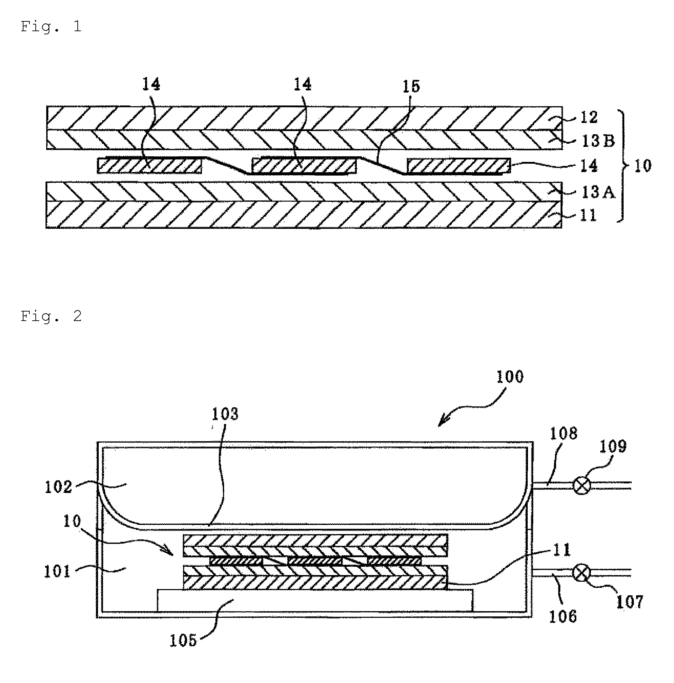

In order to produce a solar cell module, a method is employed in which a light-receiving side transparent protective member 11, a light-receiving side sealing film 13A, a plurality of photovoltaic elements 14 (solar cells) electrically connected with connection tabs 15, a backside sealing film 13B, and a backside protective member 12 (back cover) are stacked in this order as shown in Fig. 1, and the obtained stack 10 is pressurized and heated to cure the light-receiving side sealing film and the backside sealing film through cross-linking, thereby adhering and integrating respective members.

### Citation List

### Patent Literature

Patent Literature 1: JP A 2008-053379

### Summary of Invention

### Problems to be solved by the Invention

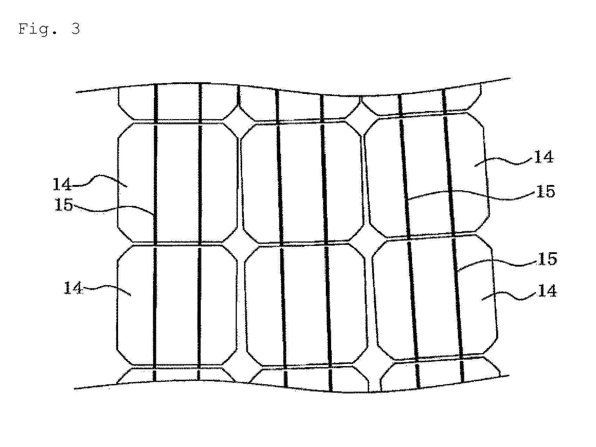

However, the sealing film on the light-receiving side and the backside as described above retains a residual strain generated in film-forming, and therefore shrinkage may sometimes occur to cause the displacement of the photovoltaic elements 14 as shown in Fig. 3 when the stack is heated (hereinafter, this phenomenon is referred to as "cell displacement"). In particular, a solar cell module with a large surface area is likely to have a large temperature difference between the center portion and the periphery portion when being heated, which frequently causes cell displacement due to the shrinkage of the sealing film in the center portion which reaches to a relatively high temperature. The occurrence of cell displacement causes problems of poor appearance, the frequent cracking of the photovoltaic element, etc. On the other hand, when the center portion is heated to a relatively low temperature at which shrinkage is less likely to occur, the periphery portion is heated insufficiently and pressurizing to laminate and integrate is sometimes initiated before the sealing film reaches to a sufficiently-molten state, which may cause the cracking of the photovoltaic element (hereinafter, this phenomenon is referred to as "cell cracking").

Accordingly, it is an object of the present invention to provide a method for manufacturing a solar cell module that can prevent cell displacement and cell cracking in heating and pressurizing, and to provide a solar cell module in which poor appearance is improved and the cracking of the photovoltaic element is reduced by using this method for manufacturing.

### Means for Solving the Problems

The above object is achieved by a method for manufacturing a solar cell module comprising the steps of stacking a light-receiving side transparent protective member, a light-receiving side sealing film, a photovoltaic element, a backside sealing film and a backside protective member in this order to obtain a stack, and heating and pressurizing the stack to integrate the stack, wherein
the light-receiving side sealing film and the backside sealing film are each formed of a different resin composition from each other selected from a resin composition A and a resin composition B,
both of the sealing films are heated when the pressurizing is initiated so as to reach to a minimum temperature X°C and a maximum temperature Y°C,
the resin composition A has a viscosity of 5.0×10⁴ Pa·s or less at the temperature X°C, and
the resin composition B has a viscosity of 7.0×10⁴ Pa·s or less at the temperature X°C and has a viscosity of 2.0×10⁴ Pa·s or more at the temperature Y°C.

In order to prevent cell displacement and cell cracking, it is necessary to heat sealing films considering the temperature difference between respective sites, that is, the minimum temperature and the maximum temperature of the sealing film in heating. According to the above configuration of the present invention, when the pressurizing is initiated in laminating and integrating, at least the resin composition B keeps a viscosity of 2.0×10⁴ Pa·s or more at which shrinkage is less likely to occur, and thereby, even if the resin composition A has a viscosity at which shrinkage is likely to occur, the shrinkage can be reduced, which enables to prevent cell displacement. Further, if at least the resin composition A is in a sufficiently-molten state in which the viscosity thereof is 5.0×10⁴ Pa·s or less when the pressurizing is initiated in laminating and integrating, because the resin composition B has a minimal viscosity of 7.0×10⁴ Pa·s or less, it is possible to pressurize to laminate and integrate respective members without occurrence of any cell cracking.

The preferred aspects of the method for manufacturing a solar cell module according to the present invention are as follows.

(1) The smaller value of N - M (°C) and N - L (°C) is 8°C or more, where M°C is a temperature at which the resin composition B has a viscosity of 7.0×10⁴ Pa·s, N°C is a temperature at which the resin composition B has a viscosity of 2.0×10⁴ Pa·s, and L°C is a temperature at which the resin composition A has a viscosity of 5.0×10⁴ Pa·s.
   A temperature region of 8°C or more is ensured in which the viscosity of the resin composition B is less likely to cause cell displacement and cell cracking, which makes a precise temperature adjustment unnecessary. In particular, cell displacement and cell cracking can be reduced in the lamination and integration of a large-sized solar cell module in which the temperature difference is large between the center portion and the periphery portion.
(2) N is 85 to 125°C.
(3) M is 70 to 95°C.
(4) L is 65 to 90°C.
(5) The larger value of M + (Y - X) and L + (Y - X) is 100°C or less.
(6) The resin composition A contains an ethylene-polar monomer copolymer, and the resin composition B contains an ethylene-polar monomer copolymer and a polyethylene.
(7) The ethylene-polar monomer copolymer is an ethylene-vinyl acetate copolymer.
(8) The light-receiving side sealing film is formed of the resin composition A, and the backside sealing film is formed of the resin composition B. A solar cell module excellent in durability can be obtained.
(9) The pressurizing and heating are performed by using a heat laminator provided with a rubber for pressurizing the stack and a heating board for heating the stack, the stack is mounted on the heating board so that the light-receiving side transparent protective member contacts with the heating board, and is pressurized by using the rubber from a side of the backside protective member.

Further, the above object can be also achieved by a solar cell module obtained by the method for manufacturing a solar cell module according to the present invention.

### Effects of Invention

According to the present invention, cell displacement and cell cracking can be prevented in heating and pressurizing to laminate respective members of a solar cell module. Accordingly can be obtained a solar cell module in which a poor appearance is improved and the cracking of the photovoltaic element is reduced.

### Brief Description of Drawings

[Fig. 1] Fig. 1 is a schematic cross-sectional view of a solar cell module.
[Fig. 2] Fig. 2 is a schematic cross-sectional view of a common vacuum laminator.
[Fig. 3] Fig. 3 is a plan view of a photovoltaic element viewed from the light-receiving side showing a situation of cell displacement.

### Mode for carrying out the Invention

As described above, in the method for manufacturing a solar cell module according to the present invention, the light-receiving side sealing film and the backside sealing film are each formed of a different resin composition from each other selected from the resin composition A and the resin composition B, both of the sealing films are heated when the pressurizing is initiated in laminating the respective members of the module so as to reach to the minimum temperature X°C and the maximum temperature Y°C, the resin composition A has a viscosity of 5.0×10⁴ Pa·s or less at the temperature X°C, and the resin composition B has a viscosity of 7.0×10⁴ Pa·s or less at the temperature X°C and has a viscosity of 2.0×10⁴ Pa·s or more at the temperature Y°C.

The smaller value of N - M (°C) and N - L (°C) is preferably 8°C or more, more preferably 10°C or more, and particularly preferably 15°C or more, where M°C is a temperature at which the resin composition B has a viscosity of 7.0×10⁴ Pa·s, N°C is a temperature at which the resin composition B has a viscosity of 2.0×10⁴ Pa·s, and L°C is a temperature at which the resin composition A has a viscosity of 5.0×10⁴ Pa·s. In this way, a viscosity at which cell displacement and cell cracking are less likely to occur is ensured in a broad temperature range, that is, a viscosity change from a high viscosity to a low viscosity due to the increase of temperature is moderate, which facilitates temperature control for laminating the respective members of the solar cell module in a state in which cell displacement and cell cracking are less likely to occur, and makes a precise temperature adjustment unnecessary. Particularly in a large-sized solar cell module in which the temperature difference is large between the center portion and the periphery portion, the occurrence of cell displacement and cell cracking can be reduced which are likely to occur in the case that an EVA is used as a sealing film on the light-receiving side and the backside in a conventional manner. A large-sized solar cell module is, for example, one having a size of more than 250,000 mm² (in the case of a square, 500 mm × 500 mm).

In addition, with the above M (°C) and L (°C) satisfying the relationship of M ≥ L, N - M (°C) is preferably 8°C or more, more preferably 10°C or more, and particularly preferably 15°C or more. That is, in the case of 8°C or more, the viscosity change of the resin composition B from 7.0×10⁴ Pa·s to 2.0×10⁴ Pa·s is moderate, which further facilitates temperature control within a range in which cell cracking and cell displacement do not occur.

Further, the temperature (M°C) at which the viscosity of the resin composition B is 7.0×10⁴ Pa·s is preferably 70 to 95°C, and particularly preferably 70 to 90°C, and the temperature (N°C) at which the viscosity of the resin composition B is 2.0×10⁴ Pa·s is preferably 85 to 125°C, and particularly preferably 90 to 120°C. Furthermore, the temperature (L°C) at which the viscosity of the resin composition A is 5.0×10⁴ Pa·s is preferably 65 to 90°C, and particularly preferably 70 to 85°C.

By selecting the resin compositions A and B having such physical properties respectively, a viscosity at which cell displacement and cell cracking are less likely to occur can be easily ensured in a broad temperature range.

The above viscosity can be determined by measuring a viscosity with a Capilograph ID (furnace body diameter: φ9.55 mm, capillary: φ1.0×10 mm, manufactured by TOYO SEIKI KOGYO, CO., LTD.) at an interval of 1°C under conditions that the test velocity is 1 mm/min.

In addition, the lower limit temperature of a temperature width in which pressurizing can be initiated represented by the larger value of M + (Y - X) and L + (Y - X) is preferably 100°C or lower, and particularly preferably 95°C or lower. In the case of over 100°C, a heating time required for reaching to a sufficient viscosity for laminating a solar cell module, that is, a heating time until a molten state is achieved is long, and therefore the efficiency is sometimes deteriorated. In the case of 100°C or lower, which enables to make the heating time relatively short, an efficient modularization can be achieved.

In the present invention, it is preferable that the resin composition A comprise an ethylene-polar monomer copolymer as the base polymer and the resin composition B comprise an ethylene-polar monomer copolymer and a polyethylene as the base polymer.

In contrast to the resin composition A comprising an ethylene-polar monomer copolymer, the resin composition B can surely ensure a relatively higher viscosity than that of the resin composition A in a broad temperature region because the resin composition B comprises a polyethylene in addition to an ethylene-polar monomer.

Examples of a polar monomer of an ethylene-polar monomer copolymer (also referred to as "EPM") include unsaturated carboxylic acids, salts thereof, esters thereof, amides thereof, vinyl esters and carbon monoxide. More specifically, the examples include one or two or more of unsaturated carboxylic acids such as acrylic acid, methacrylic acid, fumaric acid, itaconic acid, monomethyl maleate, monoethyl maleate, maleic anhydride and itaconic anhydride; monovalent metal (such as lithium, sodium and potassium) salts and multivalent metal (such as magnesium, calcium and zinc) salts of these unsaturated carboxylic acids; unsaturated carboxylates such as methyl acrylate, ethyl acrylate, isopropyl acrylate, isobutyl acrylate, n-butyl acrylate, isooctyl acrylate, methyl methacrylate, ethyl methacrylate, isobutyl methacrylate and dimethyl maleate; vinyl esters such as vinyl acetate and vinyl propionate; and carbon monoxide, sulfur dioxide and the like.

More specifically, representative examples of the ethylene-polar monomer copolymer include ethylene-unsaturated carboxylic acid copolymers such as ethylene-acrylic acid copolymers and ethylene-methacrylic acid copolymers; ionomers of the ethylene-unsaturated carboxylic acid copolymer in which a part or all of the carboxyl groups are neutralized with the above metals; ethylene-unsaturated carboxylate copolymers such as ethylene-methyl acrylate copolymers, ethylene-ethyl acrylate copolymers, ethylene-methyl methacrylate copolymers, ethylene-isobutyl acrylate copolymers and ethylene-n-butyl acrylate copolymers; ethylene-unsaturated carboxylate-unsaturated carboxylic acid copolymers such as ethylene-isobutyl acrylate-methacrylic acid copolymers and ethylene-n-butyl acrylate-methacrylic acid copolymers and ionomers thereof in which a part or all of the carboxyl groups are neutralized with the above metals; and ethylene-vinyl ester copolymers such as ethylene-vinyl acetate copolymers. These can be used singly or in a mixture of two or more thereof.

In the present invention, as an ethylene-polar monomer copolymer, an ethylene-vinyl acetate copolymer (EVA) or an ethylene-methyl methacrylate copolymer (EMMA) is preferably used, and an EVA is particularly preferably used. These are not only excellent in transparency required for the sealing film, but also have a moderate flexibility, and therefore a solar cell sealing film can be formed which can surely prevent cell displacement and cell cracking in pressurizing when a solar cell module is produced.

The light-receiving side sealing film and the backside sealing film are each formed of a different resin composition from each other selected from the resin composition A and the resin composition B. When the resin composition A contains an EPM and the resin composition B contains an EPM and a polyethylene, it is preferable that the light-receiving side sealing film be formed of the resin composition A and the backside sealing film be formed of the resin composition B. When the resin composition B is a mixture of an EPM and a polyethylene, it may be difficult to ensure transparency. Thus, when the resin composition B is used for the light-receiving side sealing film, the efficiency of power generation may be deteriorated because the transmission of the solar light is prevented. In contrast, the sealing film formed of an EPM makes it easy to ensure an excellent transparency and is suitable for forming the light-receiving side sealing film.

When the resin composition B contains a resin mixture of an ethylene-polar monomer copolymer (EPM) and a polyethylene (PE), the mass ratio of the EPM to the PE (EPM:PE) is preferably 8:2 to 3:7, and more preferably 6:4 to 3:7. This range makes it possible to ensure a higher viscosity than that of the resin composition A in a broad temperature region, and to obtain a sufficient adhesiveness as a sealing film.

In the case that an EVA is employed as the ethylene-polar monomer copolymer, the vinyl acetate content ratio of the EVA contained in the resin composition B is preferably 20 to 35% by mass, and more preferably 20 to 32% by mass. The vinyl acetate content ratio of the EVA contained in the resin composition A is preferably 20 to 35% by mass, and particularly preferably 24 to 32% by mass. These ranges make it possible to obtain a resin composition with a viscosity suitable for the present invention. In the present invention, the vinyl acetate content ratio of EVA is a value measured with the method described in JIS K 6924-1.

As the ethylene-polar monomer copolymer which can be used for the resin composition A and the resin composition B, an ethylene-polar monomer copolymer having a melt flow rate defined in JIS K 7210 of 35 g/10 min or less, particularly 3 to 30 g/10 min is preferably used. This is advantageous in preventing cell displacement and cell cracking and enables to obtain good sealing properties. Note that the value of a melt flow rate (MFR) in the present invention is measured under conditions of 190°C and 21.18 N of loading in accordance with JIS K 7210.

In the case that the resin composition B contains a polyethylene, the polyethylene is a polymer primarily composed of ethylene as defined in JIS, and includes homopolymers of ethylene, copolymers of ethylene and 5 mol% or less of an α-olefin having 3 or more, particularly 3 to 8 carbon atoms (e.g., butene-1, hexene-1, 4-methylpentene-1, octene-1, etc.), and copolymers of ethylene and 1 mol% or less of a non-olefin monomer having only carbon, oxygen and hydrogen atoms in the functional group (JIS K 6922-1: 1997). PEs are generally classified according to the density and examples thereof include high density polyethylenes (HDPEs), low density polyethylenes (LDPEs) and linear low density polyethylenes (LLDPEs).

An LDPE generally has a long chain branch obtained by polymerizing ethylene under a high pressure of 100 to 350 MPa in the presence of a radical generator such as an organic peroxide, and the density thereof is generally 0.910 g/cm³ or more and less than 0.930 g/cm³ (This is in accordance with JIS K 7112. The same is applied hereinafter.). An LLDPE is generally obtained by copolymerizing ethylene and an α-olefin in the presence of a transition metal catalyst such as a Ziegler-type catalyst, a Phillips catalyst and a metallocene-type catalyst, and the density thereof is generally 0.910 to 0.940 g/cm³, and preferably 0.910 to 0.930 g/cm³. An HDPE is a polyethylene generally having a density of 0.942 to 0.970 g/cm³. The polyethylene used in the present invention is preferably a low density polyethylene or a liner low density polyethylene from the viewpoint of workability.

In the present invention, the resin composition A and the resin composition B preferably contain a cross-linking agent for forming a cross-linking structure of the base polymer contained in each of them. An organic peroxide or a photoinitiator is preferably employed as the cross-linking agent. Especially, an organic peroxide is preferably employed because a sealing film excellent in adhesive strength and humidity resistance can be obtained.

Any organic peroxide can be used as long as it is decomposed to generate a radical at a temperature of 100°C or higher. Selection of the organic peroxide is made generally in view of film-forming temperature, adjustment conditions for the composition, curing temperature, the heat resistance of an adherend and storage stability. Particularly, an organic peroxide having a half-life of 10 hours and a decomposition temperature of 70°C or higher is preferred.

From the viewpoint of the processing temperature/storage stability of the resin, examples of the organic peroxide include benzoyl peroxide-based curing agents, tert-hexylperoxypivalate, tert-butylperoxypivalate, 3,5,5-trimethylhexanoyl peroxide, di-n-octanoyl peroxide, lauroyl peroxide, stearoyl peroxide, 1,1,3,3-tetramethylbutylperoxy-2-ethylhexanoate, succinic acid peroxide, 2,5-dimethyl-2,5-di(tert-butylperoxy)hexane, 2,5-dimethyl-2,5-di(2-ethylhexanoylperoxy)hexane, 1-cyclohexyl-1-methylethylperoxy-2-ethylhexanoate, tert-hexylperoxy-2-ethylhexanoate, 4-methylbenzoyl peroxide, tert-butylperoxy-2-ethylhexanoate, m-toluoyl+benzoyl peroxide, benzoyl peroxide, 1,1-bis(tert-butylperoxy)-2-methylcyclohexanate, 1,1-bis(tert-hexylperoxy)-3,3,5-trimethylcyclohexanate, 1,1-bis(tert-hexylperoxy)cyclohexanate, 1,1-bis(tert-butylperoxy)-3,3,5-trimethylcyclohexane, 1,1-bis(tert-butylperoxy)cyclohexane, 2,2-bis(4,4-di-tert-butylperoxycyclohexyl)propane, 1,1-bis(tert-butylperoxy)cyclododecane, tert-hexylperoxyisopropyl monocarbonate, tert-butylperoxymaleic acid, tert-butylperoxy-3,3,5-trimethylhexane, tert-butylperoxylaurate, 2,5-dimethyl-2,5-di(methylbenzoylperoxy)hexane, tert-butylperoxyisopropyl monocarbonate, tert-butylperoxy-2-ethylhexyl monocarbonate, tert-hexylperoxybenzoate and 2,5-dimethyl-2,5-di(benzoylperoxy)hexane.

Any benzoyl peroxide-based curing agent can be used as long as it is decomposed to generate radicals at a temperature of 70°C or higher, but a benzoyl peroxide-based curing agent having a half-life of 10 hours and a decomposition temperature of 50°C or higher is preferred and can be appropriately selected in view of preparation conditions, film-forming temperature, curing (laminating) temperature, the heat resistance of an adherend and storage stability. Examples of the benzoyl peroxide-based curing agent which can be used include benzoyl peroxide, 2,5-dimethylhexyl-2,5-bisperoxybenzoate, p-chlorobenzoyl peroxide, m-toluoyl peroxide, 2,4-dichlorobenzoyl peroxide, and t-butylperoxybenzoate. One benzoyl peroxide-based curing agent may be used or two or more thereof may be used in combination.

Particularly preferably, 2,5-dimethyl-2,5-di(t-butylperoxy)hexane is used as the organic peroxide. With regard to both of the resin compositions A and B, the content of the organic peroxide is preferably 0.1 to 5 parts by mass, and more preferably 0.2 to 3 parts by mass based on 100 parts by mass of the base polymer.

Further, although any known photoinitiator can be used as the photoinitiator, a photoinitiator having a good storage stability after formulation is desired. Examples of such a photoinitiator which can be used include an acetophenone-based photoinitiator such as 2-hydroxy-2-methyl-1-phenylpropan-1-one, 1-hydroxycyclohexylphenylketone and 2-methyl-1-(4-(methylthio)phenyl)-2-morpholinopropan-1-one; a benzoin-based photoinitiator such as benzyl dimethylketal; a benzophenone-based photoinitiator such as benzophenone, 4-phenylbenzophenone and hydroxybenzophenone; a thioxanthone-based photoinitiator such as isopropylthioxanthone and 2,4-diethylthioxanthone; and methylphenylglyoxylate as a special photoinitiator. Particularly preferably, examples thereof include 2-hydroxy-2-methyl-1-phenylpropan-1-one, 1-hydroxycyclohexylphenylketone, 2-methyl-1-(4-(methylthio)phenyl)-2-morpholinopropan-1-one and benzophenone. These photoinitiators can be used as necessary in a mixture with one or two or more of known and conventional photopolymerization accelerators such as a benzoic acid-based photoinitiator (e.g., 4-dimethylaminobenzoic acid) and a tertiary amine-based photoinitiator in an arbitrary ratio. Further, the photoinitiator can be used alone, and one photoinitiator can be used alone or a mixture of two or more thereof can be used.

With regard to both of the resin compositions A and B, the content of the photoinitiator is preferably 0.1 to 5 parts by mass, and more preferably 0.2 to 3 parts by mass based on 100 parts by mass of the base polymer.

The resin composition A and the resin composition B may further contain a cross-linking aid as necessary. A cross-linking aid can improve the gel fraction of the resin contained in each resin composition to improve the adhesiveness and the durability of the sealing film.

With regard to both of the resin compositions A and B, the content of the cross-linking aid to be used is generally 10 parts by mass or less, preferably 0.1 to 5 parts by mass, and more preferably 0.1 to 2.5 parts by mass based on 100 parts by mass of the base polymer. This enables to obtain a sealing film excellent in adhesiveness.

Examples of the cross-linking aid (compound having a radical-polymerizable group as a functional group) include, trifunctional cross-linking aids such as triallyl cyanurate and triallyl isocyanurate, monofunctional or bifunctional cross-linking aids such as (meth)acrylates (e.g., an NK ester, etc.). Among them, triallyl cyanurate and triallyl isocyanurate are preferred, and triallyl isocyanurate is particularly preferred.

The resin composition A and the resin composition B preferably have an excellent adhesive strength in view of sealing performance within a solar cell module. For this purpose, an adhesiveness-improving agent may be further contained. A silane coupling agent can be used as the adhesiveness-improving agent. This enables to form a solar cell sealing film having an excellent adhesive strength. Examples of the silane coupling agent include γ-chloropropylmethoxysilane, vinyltriethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane, and N-β-(aminoethyl)-γ-aminopropyltrimethoxysilane. These silane coupling agents may be used singly, or in combinations of two or more. Among them, γ-methacryloxypropyltrimethoxysilane is particularly preferred.

With regard to both of the resin compositions A and B, it is preferable that the content of the silane coupling agent be 5 parts by mass or less, and preferably 0.1 to 2 parts by mass based on 100 parts by mass of the base polymer.

The resin composition A or the resin composition B forming the backside sealing film may contain a coloring agent. The coloring agent is appropriately selected so as to provide a desired color tone, and for example, a white coloring agent such as titanium white (titanium dioxide) and calcium carbonate can be used. The content of the coloring agent is generally 0.1 to 10 parts by weight, and more preferably 0.5 to 6 parts by mass based on 100 parts by weight of the base polymer of the resin composition A or B in the backside sealing film.

The light-receiving side sealing film and the backside sealing film may contain a plasticizer, various additives such as an acryloxy group-containing compound, a methacryloxy group-containing compound and/or an epoxy group-containing compound, an ultraviolet absorber, a photostabilizer and an antioxidant as necessary in order to improve or adjust the various physical properties (such as mechanical strength, optical properties, heat resistance, light resistance and cross-linking rate) of the film.

Forming of the light-receiving side sealing film and the backside sealing film may be performed in accordance with a known method. For example, they can be manufactured by a method in which a composition containing the above-described components is molded to provide a sheet by using common extrusion molding, calender molding (calendering) or the like. The thickness of the light-receiving side sealing film and the backside sealing film is, although not particularly limited, 0.5 to 2 mm.

The method for manufacturing a solar cell module according to the present invention is performed, as shown in Fig. 1, by laminating a light-receiving side transparent protective member 11, a light-receiving side sealing film 13A, photovoltaic elements 14, a backside sealing film 13B and a backside protective member 12 in this order to obtain a stack 10, and heating and pressurizing the stack 10 to integrate the stack. In the present invention, the pressurizing and heating are performed by using a heat laminator provided with a rubber for pressurizing the stack 10 and a heating board for heating the stack 10, and it is preferable that the stack 10 be mounted on the heating board so that the light-receiving side transparent protective member contacts with the heating board, and be pressurized by using the rubber from the side of the backside protective member. This step of pressurizing and heating the stack 10 is preferably performed by using a vacuum laminator having an expandable rubber (diaphragm made of rubber), particularly a vacuum laminator with a dual vacuum chamber system shown in Fig. 2.

The vacuum laminator 100 shown in Fig. 2 has a top chamber 102 including a rubber 103 and a bottom chamber 101 including a mounting table 105 for mounting the stack 10. In the vacuum laminator 100, the top chamber 102 and the bottom chamber 101 are evacuated to vacuum and thereafter the stack 10 is pressurized by the rubber 103. The evacuation to vacuum of the top chamber 102 and the bottom chamber 101 is performed with a bottom chamber vacuum pump 107 connected to a bottom chamber outlet 106 and a top chamber vacuum pump 109 connected to a top chamber outlet 108.

In order to pressurize the stack 10 by using such a vacuum laminator, first, the stack 10 in which the light-receiving side transparent protective member 11, the light-receiving side sealing film 13A, the photovoltaic elements 14, the backside sealing film 13B, and the backside protective member 12 are stacked in this order is mounted on the mounting table 105 provided within the bottom chamber 101. Next, the pressures in the top chamber 102 and the bottom chamber 101 are reduced to vacuum with the top chamber vacuum pump 109 and the bottom chamber vacuum pump 107, respectively, and thereafter the pressure in the top chamber 102 is preferably set to a pressure greater than or equal to the atmospheric pressure. Thereby, the uppermost surface of the stack 10 is pressed by the rubber 103 and the stack 10 is pressurized.

In order to evacuate to vacuum each of the top chamber 102 and the bottom chamber 101, first, the pressure in each of the top chamber 102 and the bottom chamber 101 is preferably reduced to 50 to 150 Pa, particularly 50 to 100 Pa. The evacuating time is, for example, set to 0.1 to 5 min. Thereafter, the pressure in the top chamber is set to 40 to 110 kPa, particularly 60 to 105 kPa to homogeneously pressurize the stack by the rubber 103.

The expanding rate of the rubber is preferably adjusted so that the stack is pressurized in a pressure of 1.0×10³ Pa to 5.0×10⁷ Pa, particularly 60 to 105 kPa. The pressurizing time is, for example, 5 to 15 min.

In the method according to the present invention, the pressurizing is performed along with heating. Examples of the heating method include a method of heating the whole of the vacuum laminator 100 shown in Fig. 2 in a high temperature environment such as an oven, and a method of heating the stack 10 by introducing a heating medium such as a heating board into the bottom chamber 101 of the vacuum laminator 100 shown in Fig. 2, and the latter method is preferred. The heating is performed by using a heating board as the mounting table 105, disposing a heating board on the upper and/or lower side(s) of the mounting table 105, or disposing a heating board on the upper and/or lower side(s) of the stack, and using a heating board as the mounting table 105 is common from the viewpoint of workability and a good modularization.

However, in the case of heating from the side of the light-receiving side transparent protective member 11 by using a heating board, the light-receiving side transparent protective member 11 (usually, glass is employed) is warped, and therefore, in particular, the center portion of the stack is most likely to be heated, frequently leading to a higher temperature than that in the periphery portion. Further, the larger the surface area of the stack, the greater the temperature difference between the center portion and the periphery portion tends to be in heating. Accordingly, in the method for manufacturing according to the present invention, it is possible to particularly effectively prevent cell displacement and cell cracking in the case of heating and pressurizing the stack by using a heat laminator provided with such a heating board.

It is to be noted that when the heating is performed, usually, the above maximum temperature Y°C tends to be the temperature at the center of gravity of the plane shape of the sealing film, and the minimum temperature tends to be the temperature at the most distant position from the center of gravity of the sealing film. For example, in the case of a sealing film with a rectangular shape, the maximum temperature Y°C is the temperature at a position of the center of gravity of the sealing film, and the minimum temperature X°C is the temperature at the four corners of the sealing film.

It is preferable that the stack 10 be heated to a temperature of 130 to 170°C, preferably 140 to 160°C. The pressurizing by the above rubber is initiated in the course of temperature elevation due to the heating. That is, the heating is performed so that the temperatures of both of the light-receiving side sealing film 13A and the backside sealing film 13B reach to the minimum temperature X°C and the maximum temperature Y°C in the heating process. The temperature of the sealing film may be measured in any manner. For example, the temperature of the sealing film can be measured by using a thermocouple and a thermo-label.

The pressurizing is initiated in a state in which the temperatures of both of the solar cell sealing films 13A and 13B have reached to the minimum temperature X°C and the maximum temperature Y°C, the temperature is further raised after the initiation of the pressurizing, and after reaching to the above temperature range, the state is retained for a certain period.

In the present invention, cell displacement and cell cracking can be prevented by forming the sealing film with the resin compositions A and B having the above-described viscosity properties, and heating and pressurizing the stack 10 under the above-described heating conditions.

Hereinafter, other members used in the method for manufacturing a solar cell module according to the present invention will be described in detail.

As the light-receiving side transparent protective member used for a solar cell module, for example, a glass substrate such as a silicate glass can be usually used. The thickness of the light-receiving side transparent protective member is generally 0.1 to 10 mm, and preferably 0.3 to 5 mm. Generally, the light-receiving side transparent protective member may be one which has been chemically or thermally reinforced.

As the backside protective member used for a solar cell module, plastic films such as a polyethylene terephthalate (PET) and a polyamide are preferably employed. Alternatively, in view of heat resistance or humidity/heat resistance, a polyethylene fluoride film, particularly a film in which a polyethylene fluoride film/Al/a polyethylene fluoride film are laminated in this order or a film in which a polyvinyl fluoride (trade name: Tedlar)/a PET/a polyvinyl fluoride are laminated in this order may be employed.

The photovoltaic element used for a solar cell module performs photoelectric conversion, and a conventionally known semiconductor substrate is employed for it. As the semiconductor substrate, for example, a photosemiconductor element composed of a monocrystal, a polycrystal or an amorphous is employed. Specifically, in addition to an amorphous silicon (a-Si), a hydrogenated amorphous silicon (a-Si:H), a hydrogenated amorphous silicon carbide (a-SiC:H) and an amorphous silicon nitride, a semiconductor layer is employed in which an amorphous or a microcrystal of an amorphous silicon-based semiconductor consisting of an alloy of silicon and other element such as carbon, germanium and tin is configured to be a pin-type, an nip-type, an ni-type, a pn-type, an MIS-type, a heterojunction-type, a homojunction-type, a Schottky barrier-type or a type in combination thereof. Alternatively, the photosemiconductor layer may be CdS-based, GaAs-based or InP-based one or the like.

Incorporation of the photovoltaic element in a solar cell module may be performed in accordance with a conventionally known method. For example, an inner lead of a copper foil or the like which has been subjected to solder plating or the like is connected to the electrode of the photovoltaic element, and the photovoltaic elements are further connected to each other in series-parallel with inner leads so that a predetermined electric output can be taken from the solar cell module.

### Examples

Hereinafter, the present invention will be described in more detail with reference to Examples.

### 1. Production of light-receiving side sealing film and backside sealing film

The materials with the respective proportions shown in Table 1 were supplied to a roll mill and kneaded. Thus obtained resin composition (the resin composition A or B) for a sealing film was calender-molded at 75 to 85°C to produce a light-receiving side sealing film and a backside sealing film (thickness: 0.5 mm). They were made into two types with size A (600 mm × 600 mm) and size B (900 mm × 900 mm), respectively.

### 2. Production of solar cell module

A light-receiving side transparent protective member (a white tempered glass (embossed), thickness: 3 mm)/the above light-receiving side sealing film/photovoltaic elements (a monocrystalline silicon cell, thickness: 300 µm)/the above backside sealing film/a backside protective member (a PET, thickness: 500 µm) were stacked in this order, and thereafter the stack was adhered and integrated (laminated) to produce a solar cell module by heating and pressurizing with a vacuum laminator with a dual vacuum chamber system as shown in Fig. 2 under conditions of a evacuating time of 5 min, a pressure of 0.1 MPa and a press time of 10 min. Two types of solar cell modules were produced each of which had a size corresponding to one of the two sizes (size A and size B) of the above sealing films.

The pressurizing of the stack was performed by mounting the stack on a mounting table within the laminator so that the light-receiving side transparent protective member was positioned in the lower side and pressing it with a rubber from the side of the backside protective member. The heating was performed by using a heating board as a mounting table and preheating to 150°C. The pressurizing was initiated at a stage in which the temperatures of both sealing films were elevated to the sealing film temperature at the initiation of the pressurizing (the minimum temperature and the maximum temperature) shown in Table 2. In order to confirm the temperature of each sealing film at the initiation of the pressurizing, a K-type thermocouple connected to an NR 1000 manufactured by KEYENCE CORPORATION was attached on the center portion and the periphery portion of the sealing film, and the temperature was measured. The minimum temperature X°C shown below is the temperature at the periphery portion of the sealing film and the maximum temperature Y°C is the temperature at the center portion of the sealing film.

### <Evaluation method>

### 1. Laminate properties

### (1) Temperature width in which pressurizing can be initiated

In the case that each of the sealing film is heated to a state in which the pressurizing can be initiated, represented as the sealing film temperature (the minimum temperature X°C and the maximum temperature Y°C) at the initiation of the pressurizing shown in Table 2, there exists a temperature difference of 10°C in the size A, and 15°C in the size B. That is, the difference between the maximum temperature Y°C and the minimum temperature X°C (Y - X) is 10°C in the size A, and the difference between the maximum temperature Y°C and the minimum temperature X°C (Y - X) is 15°C in the size B.

On the basis of the above-described temperature region in which viscosity properties which do not cause cell displacement and cell cracking can be ensured (the smaller value of N - M°C and N - L°C: shown in Table 1), calculation was performed to confirm whether there existed a temperature width (°C) in which the pressurizing could be initiated in laminating respective solar cell modules in the size A and the size B. For example, in Example 1, because the smaller value of N - M and N - L is N - M°C of 20°C and the sealing film in the size A has a temperature difference of 10°C, the temperature width in which the pressurizing can be initiated is 20°C - 10°C = 10°C.

### (2) Heating time (tact)

The solar cell modules were heated and the heating time at which the temperature of the sealing film reached to the lower limit temperature at which the pressurizing could be initiated (the higher temperature of M + (Y - X) and L + (Y - X)) was measured. A case in which the lower limit temperature was 100°C or lower (the heating time was within 5 min) was evaluated as ○, and a case in which the lower limit temperature was over 100°C (the heating time was over 5 min) as ×.

A case in which there existed a temperature width in which the pressurizing could be initiated in the above (1) and the evaluation in the above (2) was ○ was evaluated as a pass (○) in laminate properties, a case in which, although there existed a temperature width in which the pressurizing could be initiated in (1), the evaluation in (2) was × as Δ, and a case other than these cases as ×.

### 2. Durability of electromotive force

The solar cell modules produced were left to stand under an atmosphere with a temperature of 85°C and a relative humidity of 85% for 2000 hours. These solar cell modules were irradiated with a simulated sunlight with an irradiation intensity of 1000 mW/cm² at 25°C by using a solar simulator with the spectrum adjusted to AM 1.5, the open circuit voltage [V], the nominal maximum output operating current per 1 cm² [A], and the nominal maximum output operating voltage [V] were measured for each of the solar cells. The nominal maximum output A1 [W] (JIS C 8911 1998) was determined from the multiplication of them, and compared with the initial value. As the result, a case in which the reduction in the A1 [W] value was within 5% was evaluated as ○, and a case in which the reduction in the A1 [W] value was over 5% as ×.

### 3. Cell displacement/cell cracking

Each of the solar cell modules produced was subjected to visual inspection, and a case in which the solar cell module was laminated without occurrence of any displacement and cracking of the photovoltaic element was evaluated as ○.

The details about the materials listed in the Table below are as follows.
EVA (1): melting point 76°C, vinyl acetate content ratio 26% by mass, MFR 44 g/10 min (Ultrathene 634, manufactured by Tosoh Corporation)
EVA (2): melting point 95°C, vinyl acetate content ratio 10% by mass, MFR 4 g/10 min (V 210, manufactured by UBE-MARUZEN POLYETHYLENE)
PE (1): melting point 106°C, MFR 24 g/10 min, density 0.918 g/cm³, LDPE (Petrothene 202, manufactured by Tosoh Corporation)
PE (2): melting point 108°C, MFR 1.6 g/10 min, density 0.919 g/cm³, LDPE (Petrothene 360, manufactured by Tosoh Corporation)
PE (3): melting point 121°C, MFR 1.0 g/10 min, density 0.921 g/cm³, LLDPE (UF 230, manufactured by Japan Polyethylene Corporation)
Cross-linking agent: 2,5-dimethyl-2,5-di(t-butylperoxy)hexane (PERHEXA 25B, manufactured by NOF Corporation)
Cross-linking aid: triallyl isocyanurate (TAIC, manufactured by Nippon Kasei Chemical Co., Ltd)
Adhesiveness-improving agent: γ-methacryloxypropyltrimethoxysilane (KBM 503, manufactured by Shin-Etsu Chemical Co., Ltd.)

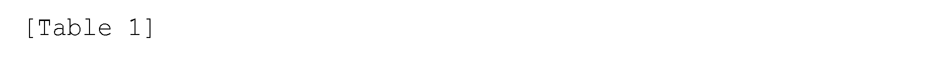

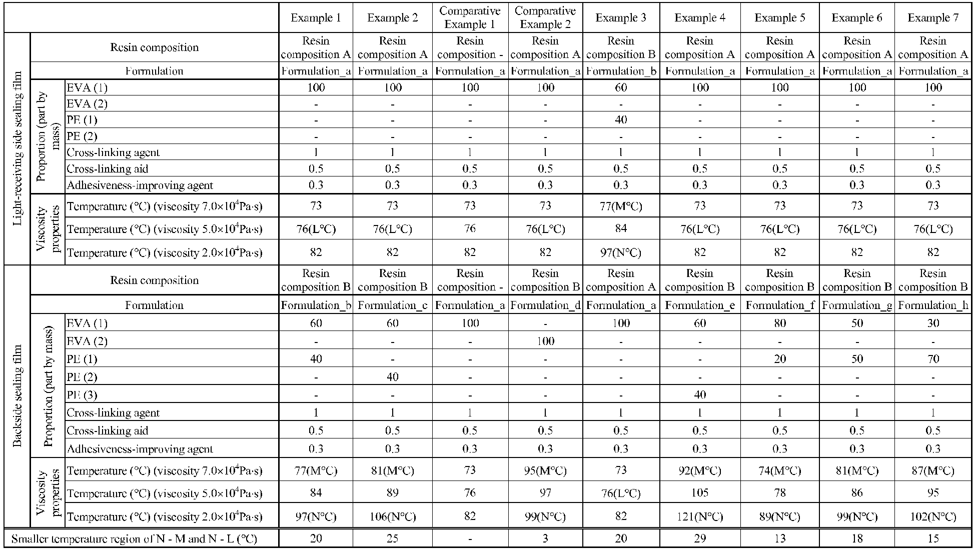

**[Table 2]**

| | | | | Example 1 | Example 2 | Comparative Example 1 | Comparative Example 2 | Example 3 | Example 4 | Example 5 | Example 6 | Example 7 |
|---|---|---|---|---|---|---|---|---|---|---|---|---|
| | Size A | Temperature range of sealing film required at initiation of pressurizing | Min Temperature (X°C) | 77-87 | 81-96 | No range | No range | 77-87 | 92-111 | 76-79 | 81-89 | 87-92 |
| | | | Max Temperature (Y°C) | 87-97 | 91-106 | No range | No range | 87-97 | 102-121 | 86-89 | 91-99 | 97-102 |
| | | Temperature width in which pressurizing can be initiated (°C) | | 10 | 15 | None | None | 10 | 19 | 3 | 8 | 5 |
| | | Sealing film temperature at initiation of pressurizing | Min Temperature (X°C) | 80 | 85 | - | - | 80 | 95 | 78 | 85 | 87 |
| | | | Max Temperature (Y°C) | 90 | 95 | - | - | 90 | 105 | 88 | 95 | 97 |
| Laminate properties | | Heating time | | ○ | ○ | - | - | ○ | × | ○ | ○ | ○ |
| | | Evaluation | | ○ | ○ | × | × | ○ | Δ | ○ | ○ | ○ |
| | Size B | Temperature range of sealing film required at initiation of pressurizing | Min Temperature (X°C) | 77-82 | 81-91 | No range | No range | 77-82 | 92-106 | No range | 81-84 | 87 |
| | | | Max Temperature (Y°C) | 92-97 | 96-106 | No range | No range | 92-97 | 107-121 | No range | 96-99 | 102 |
| | | Temperature width in which pressurizing can be initiated (°C) | | 5 | 10 | None | None | 5 | 14 | None | 3 | 0 |
| | | Sealing film temperature at initiation of pressurizing | Min Temperature (X°C) | 80 | 85 | - | - | 80 | 95 | - | 83 | 87 |
| | | | Max Temperature (Y°C) | 95 | 100 | - | - | 95 | 110 | - | 98 | 102 |
| | | Heating time | | ○ | ○ | - | - | ○ | × | - | ○ | × |
| | | Evaluation | | ○ | ○ | × | × | ○ | Δ | × | ○ | Δ |
| Durability of electromotive force | | | | ○ | ○ | ○ | ○ | × | ○ | ○ | ○ | ○ |
| Cell displacement/cell cracking | | Size A | | ○ | ○ | × | × | ○ | ○ | ○ | ○ | ○ |
| | | Size B | | ○ | ○ | × | × | ○ | ○ | × | ○ | × |
| Total evaluation | | | | ○ | ○ | × | × | Δ | Δ | Δ | ○ | Δ |

### <Evaluation result>

In Examples 1 and 2, the light-receiving side sealing film and the backside sealing film are heated to a state in which the viscosities thereof cause no cell displacement and cell cracking in pressurizing to laminate the members of the solar cell module, and thereby a solar cell module without cell displacement and cell cracking and still having good initial properties can be obtained. On the other hand, in Example 3, although cell displacement or the like was not observed, the reduction in the durability of electromotive force was confirmed. In Example 4, the result indicated that there was no cell displacement or the like and the initial properties were still good, however a relatively long heating time was required. In Example 5, no cell displacement or the like was observed and a good lamination was achieved in the size A, however, there existed no temperature width in which the pressurizing could be initiated in the size B. In Example 7, the result indicated that a relatively long heating time was required in the size B.

### Reference Signs List

- 10: stack
- 11: light-receiving side transparent protective member
- 12: backside protective member
- 13A: light-receiving side sealing film
- 13B: backside sealing film
- 14: photovoltaic element
- 15: connection tab
- 100: vacuum laminator
- 101: bottom chamber
- 102: top chamber
- 103: rubber
- 105: mounting table
- 106: bottom chamber outlet
- 107: bottom chamber vacuum pump
- 108: top chamber outlet
- 109: top chamber vacuum pump

## Claims

1. A method for manufacturing a solar cell module comprising the steps of stacking a light-receiving side transparent protective member, a light-receiving side sealing film, a photovoltaic element, a backside sealing film and a backside protective member in this order to obtain a stack, and heating and pressurizing the stack to integrate the stack, wherein
the light-receiving side sealing film and the backside sealing film are each formed of a different resin composition from each other selected from a resin composition A and a resin composition B,
both of the sealing films are heated when the pressurizing is initiated so as to reach to a minimum temperature X°C and a maximum temperature Y°C,
the resin composition A has a viscosity of 5.0×10⁴ Pa·s or less at the temperature X°C, and
the resin composition B has a viscosity of 7.0×10⁴ Pa·s or less at the temperature X°C and has a viscosity of 2.0×10⁴ Pa·s or more at the temperature Y°C.

2. The method according to claim 1, wherein a smaller value of N - M (°C) and N - L (°C) is 8°C or more, where M°C is a temperature at which the resin composition B has a viscosity of 7.0×10⁴ Pa·s, N°C is a temperature at which the resin composition B has a viscosity of 2.0×10⁴ Pa·s, and L°C is a temperature at which the resin composition A has a viscosity of 5.0×10⁴ Pa·s.

3. The method according to claim 2, wherein N is 85 to 125°C.

4. The method according to claim 2 or 3, wherein M is 70 to 95°C.

5. The method according to any one of claims 2 to 4, wherein L is 65 to 90°C.

6. The method according to any one of claims 2 to 5, wherein a larger value of M + (Y - X) and L + (Y - X) is 100°C or less.

7. The method according to any one of claims 1 to 6, wherein the resin composition A contains an ethylene-polar monomer copolymer, and the resin composition B contains an ethylene-polar monomer copolymer and a polyethylene.

8. The method according to claim 7, wherein the ethylene-polar monomer copolymer is an ethylene-vinyl acetate copolymer.

9. The method according to any one of claims 1 to 8, wherein
the pressurizing and heating are performed by using a heat laminator provided with a rubber for pressurizing the stack and a heating board for heating the stack,
the stack is mounted on the heating board so that the light-receiving side transparent protective member contacts with the heating board, and is pressurized by using the rubber from a side of the backside protective member.

10. The method according to any one of claims 1 to 9, wherein the light-receiving side sealing film is formed of the resin composition A, and the backside sealing film is formed of the resin composition B.

11. A solar cell module obtained by the method according to any one of claims 1 to 10.
